(19) Europäisches Patentamt
European Patent Office
Office européen des brevets

(11) EP 0 901 173 A1

## (12) EUROPEAN PATENT APPLICATION

(43) Date of publication:
10.03.1999 Bulletin 1999/10

(51) Int. Cl.⁶: $H01L\ 41/09$, $H01L\ 41/04$

(21) Application number: 98116071.6

(22) Date of filing: 26.08.1998

(84) Designated Contracting States:
AT BE CH CY DE DK ES FI FR GB GR IE IT LI LU
MC NL PT SE
Designated Extension States:
AL LT LV MK RO SI

(30) Priority: 08.09.1997 JP 258001/97

(71) Applicant:
WAC DATA SERVICES CO. LTD.
Fujimi-City, Saitama-ken (JP)

(72) Inventors:
• Watanabe, Chiharu
Fujimi City, Saitama-Ken (JP)
• Enomoto, Takashi
Higashi-Atsuyama-City, Saitama-Ken (JP)

(74) Representative:
Feldkamp, Rainer, Dipl.-Ing. et al
Garmischer Strasse 4
80339 München (DE)

### (54) Piezoelectric actuator

(57) Disclosed is a piezoelectric actuator for a textile machine having no problem of depolarization, which comprises a plurality of piezoelectric ceramic layers stacked, in which charging of electric charges by application of voltage to one of said plurality of piezoelectric ceramic layers and discharging thereof are alternately repeated by switching operation according to a switching element.

Fig. 1 (A)

Printed by Xerox (UK) Business Services
2.16.7/3.6

## Description

### FIELD OF THE INVENTION

The present invention relates to a piezoelectric actuator, and more particularly to a piezoelectric actuator for a textile machine, which does not produce the problem of depolarization, especially a piezoelectric actuator which can be used in a needle driving mechanism of a hosiery machine (a needle selecting arrangement for a knitting machine) or in a warp controlling mechanism of a loom.

### BACKGROUND OF THE INVENTION

When an electric field is applied to piezoelectric ceramics, cations are attracted in the electric field direction, and anions in the reverse direction to cause the strain of crystals, resulting in the deformation of the piezoelectric ceramics.

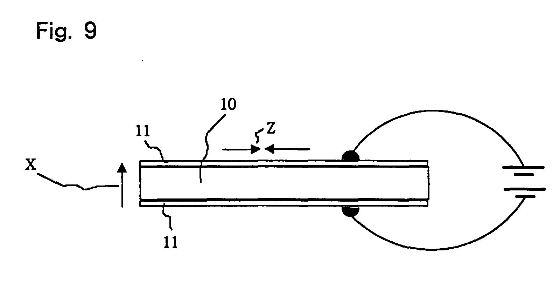

As shown in Fig. 9, the application of voltage to a piezoelectric plate 10 fitted with electrodes 11 and polarized (X) causes a strain (Z) in the longitudinal direction to change the length thereof.

However, in practice, this deformation is so small that piezoelectric plates whose deformation is enlarged by use of the bimorph operation principle has hitherto been utilized as various piezoelectric actuators.

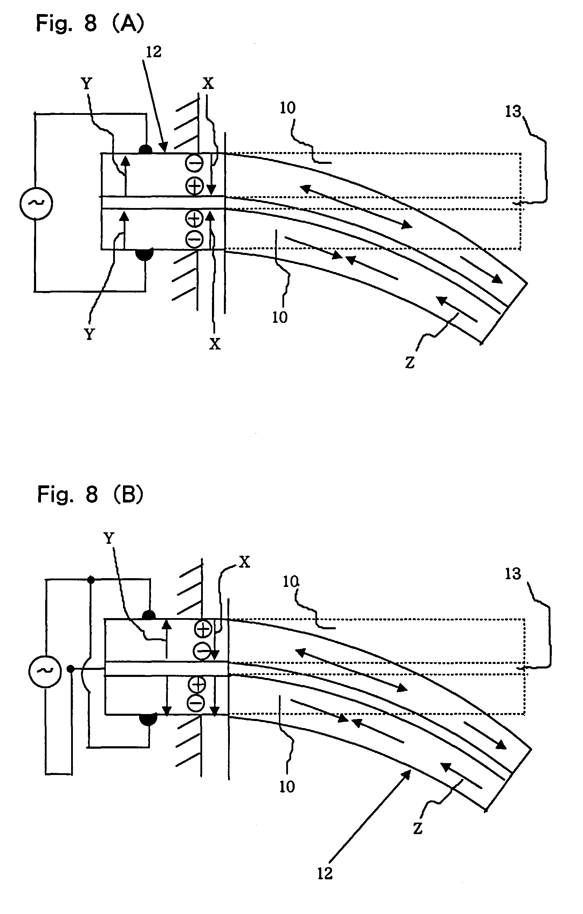

The operation principle of the conventional bimorph piezoelectric actuator is as follows. That is to say, as shown in Figs. 8(A) and 8(B), the bimorph piezoelectric actuator 12 usually comprises two thin piezoelectric ceramic plates 10 laminated with a piezoelectrically inactive shim member 13 formed of a metal plate or the like intervening therebetween so that when one of the piezoelectric ceramic plates 10 is expanded, the other is contracted, like a bimetal. This force of expansion and contraction bents the metal plate of the shim member 13 to cause bending deformation as a whole. The displacement and force are utilized in the piezoelectric actuator 12.

Figs. 8(A) and 8(B) are each views for illustrating the operation principle of the piezoelectric actuators, the former showing the principle of the series type bimorph piezoelectric actuator in which the polarization directions X are symmetrical with respect to the shim member 13, and the latter showing the principle of the parallel type bimorph piezoelectric actuator in which the polarization directions X are arranged in the same direction. In any event, it is intended to obtain the bending deformation by the force of expansion and contraction of the two piezoelectric ceramic plates 10 in the directions opposite to each other, as shown in the drawings. That is to say, when one of the piezoelectric ceramic plates 10 is expanded, the other is contracted, thereby developing the bending deformation as a whole through the shim member 13.

However, the problem of depolarization is encountered in such bimorph piezoelectric actuators 12. That is to say, in these bimorph piezoelectric actuators, a system is used in which displacement producing bending deformation in the piezoelectric ceramic plates 10 is obtained by applying voltages (electric fields) Y in the directions opposite to each other in the plate thickness direction. Voltage Y in the direction opposite to the polarization (direction) X is necessarily applied to one piezoelectric ceramic plate 10, so that depolarization takes place according to the level of the voltage Y and the time for which the voltage Y is applied. When one of the two piezoelectric ceramic plates is lowered in piezoelectric characteristics by the depolarization action, the expected amount of displacement is not obtained. It is therefore difficult to function as the piezoelectric actuator, resulting in unavoidable stoppage of a machine. The depolarization is said to unavoidably occur from an electric field of about one-third the anti-electric field (the electric field which completely extinguishes the polarization).

The depolarization is liable to occur, particularly when DC (direct current) voltage is continuously applied. It is therefore also studied that AC (alternating current) driving is conducted using a special circuit so as to alternately apply an electric field in the direction opposite to the polarization direction.

In this case, however, for allowing the bending displacement to occur as the piezoelectric actuator, in addition to charging of the electric charges caused by the application of the electric field, a problem arises with respect to a discharging means thereof.

In the above, particularly in a piezoelectric actuator for a textile machine as described later, especially in a needle driving mechanism of a hosiery machine or a warp controlling mechanism of a loom, when, for example, the knitting needles are selected by bending press and the displacing time is relatively long, the problem of depolarization becomes serious. For example, a feeler for the blind is displaced by the application of DC voltage. When the displacement is returned to the original state after the displacement for at most about 5 seconds, the recovery of polarization is rapid. However, the piezoelectric actuator for the textile machine is liable to be left displaced.

The piezoelectric actuators are described, for example, in Japanese Unexamined Patent Publication Nos. 60-249877, 60-211176, 61-15383, 55-104149 and 54-133124.

### SUMMARY OF THE INVENTION

It is therefore an object of the present invention to provide a technique which can solve such problems of the prior art.

Another object of the present invention is to provide particularly a piezoelectric actuator for a textile machine, and especially a piezoelectric actuator which can be used in a needle driving mechanism of a hosiery machine or in a warp controlling mechanism of a loom.

The above and other objects and novel features of the invention will become apparent from the whole description of this specification.

The present invention provides a piezoelectric actuator for a textile machine which is not depolarized, said actuator comprising a plurality of piezoelectric ceramic layers stacked, in which charging of electric charges by application of voltage to one of said plurality of piezoelectric ceramic layers and discharging thereof are alternately repeated by switching operation according to a switching element.

BRIEF DESCRIPTION OF THE DRAWINGS

Figs. 1(A) to 1(D) are each schematic representations showing a main part of a piezoelectric actuator embodying the present invention and for illustrating the piezoelectric operation thereof;

Fig. 2(A) is a schematic representation for illustrating the operation of said piezoelectric actuator embodying the present invention, and Fig. 2(B) is a cross sectional view showing a main part of another piezoelectric actuator embodying the present invention;

Fig. 3 is a cross sectional view showing a needle driving mechanism of a hosiery machine in which the piezoelectric actuator embodying the present invention is used;

Figs. 4(A) and 4(B) are each schematic representations for illustrating the needle driving operation of the piezoelectric actuator in the needle driving mechanism of the hosiery machine;

Fig. 5 is a schematic representation for illustrating a hosiery machine;

Fig. 6(A) is a plan view showing a warp controlling mechanism of a loom in which the piezoelectric actuator embodying the present invention is used, and Fig. 6(B) is a cross sectional view of the warp controlling mechanism shown in Fig. 5(A);

Figs. 7(A) and 7(B) are each schematic representations for illustrating the controlling operation of the piezoelectric actuator in the warp controlling mechanism of the loom;

Figs. 8(A) and 8(B) are each schematic views showing conventional bimorph piezoelectric elements; and

Fig. 9 is a schematic view showing a conventional piezoelectric element.

DESCRIPTION OF THE PREFERRED EMBODIMENTS

Embodiments of the present invention are described below with reference to the drawings.

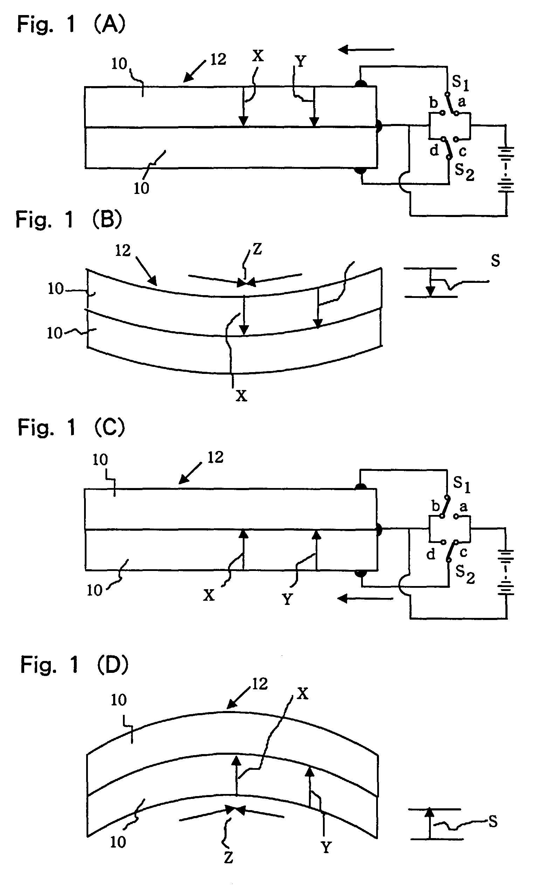

Figs. 1(A) to 1(D) are each schematic representations showing a main part of a piezoelectric actuator embodying the present invention and for illustrating the piezoelectric operation thereof.

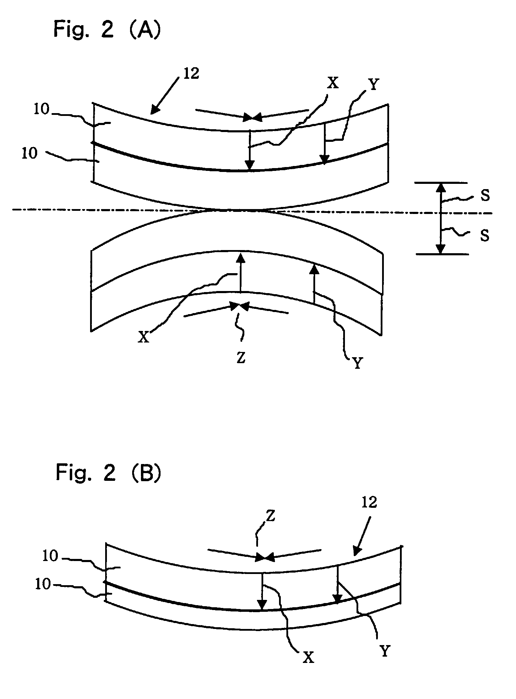

Fig. 2(A) is a schematic representation for illustrating the operation of said piezoelectric actuator embodying the present invention, and Fig. 2(B) is a cross sectional view (hatching is omitted) showing a main part of another piezoelectric actuator embodying the present invention

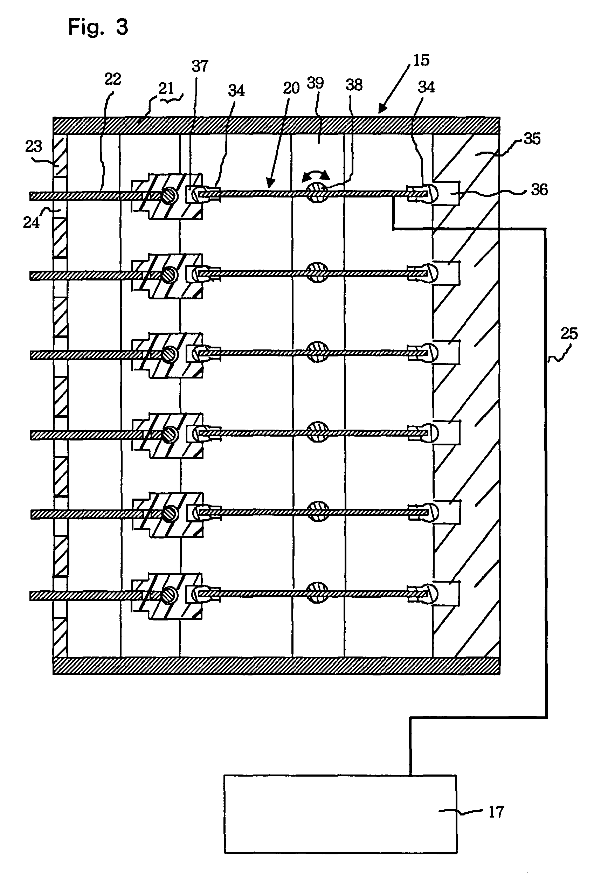

Fig. 3 is a cross sectional view showing a needle driving mechanism of a hosiery machine in which the piezoelectric actuator embodying the present invention is used.

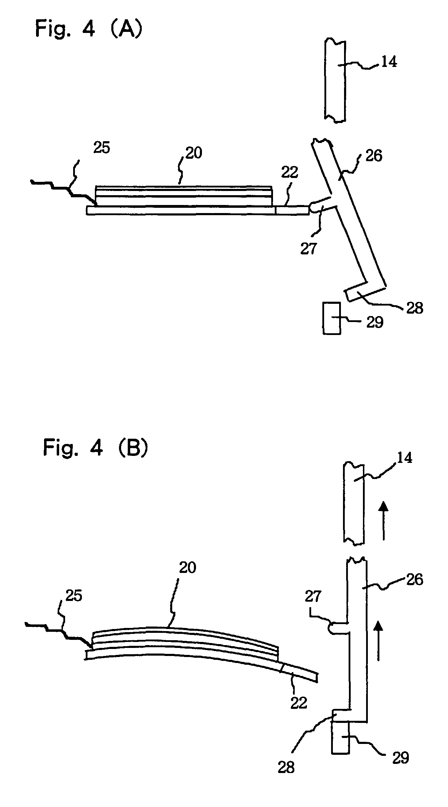

Figs. 4(A) and 4(B) are each schematic representations for illustrating the needle driving operation of the piezoelectric actuator in the needle driving mechanism of the hosiery machine.

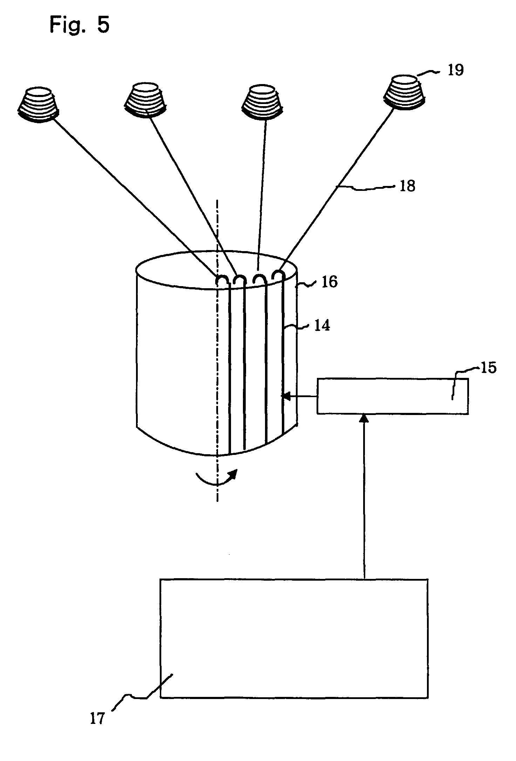

Fig. 5 is a schematic representation for illustrating a hosiery machine.

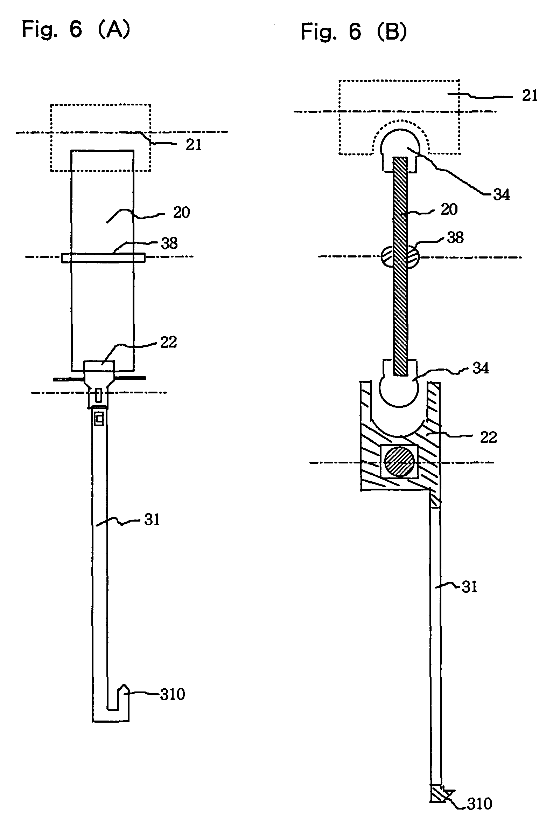

Fig. 6(A) is a plan view showing a warp controlling mechanism of a loom in which the piezoelectric actuator embodying the present invention is used, and Fig. 6(B) is a cross sectional view of the warp controlling mechanism shown in Fig. 5(A).

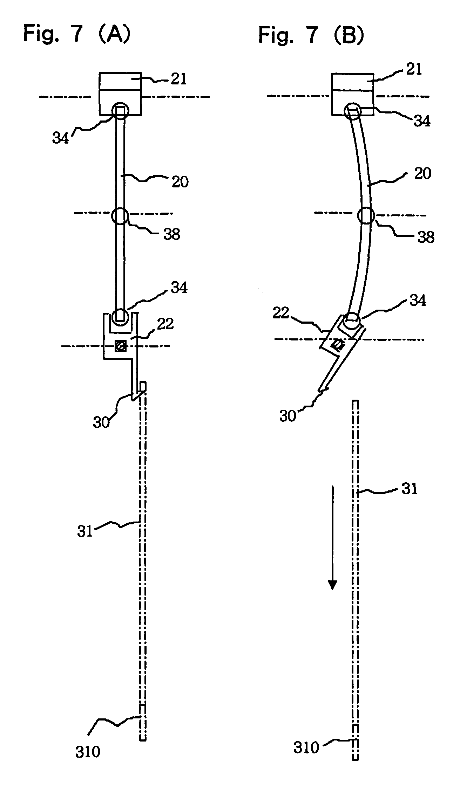

Figs. 7(A) and 7(B) are each schematic representations for illustrating the controlling operation of the piezoelectric actuator in the warp controlling mechanism of the loom.

As shown in Fig. 1(A), two piezoelectric ceramic layers 10 are laminated with each other without allowing a piezoelectrically inactive shim member formed of a metal plate or the like to intervene therebetween. A switch $S_1$ operating to the upper piezoelectric ceramic layer 10 and a switch $S_2$ operating to the lower piezoelectric ceramic layer 10 are provided, and electrically connected to a DC source (V).

As shown in Fig. 1(A), the switch $S_1$ is connected to the side a, and voltage Y is applied to the upper piezoelectric ceramic layer 10. Electric charges are charged on said upper piezoelectric ceramic layer 10 by the application of the voltage. The switch $S_2$ is turned to the side d so that no voltage is applied to the lower piezoelectric ceramic layer 10, thereby keeping the lower layer in the intact state. A strain Z is developed in the upper piezoelectric ceramic layer 10 by the application of the voltage Y, whereas the lower piezoelectric ceramic layer 10 is kept in the intact state in which no voltage is applied.

Similarly, as shown in Fig. 1(C), the switch $S_2$ is connected to the side c, and the voltage Y is applied to the lower piezoelectric ceramic layer. Electric charges are charged on said lower piezoelectric ceramic layer 10 by the application of the voltage. A strain Z is developed in the lower piezoelectric ceramic layer 10 by the application of the voltage Y. The switch $S_1$ is turned to the side b so that no voltage is applied to the upper piezoelectric ceramic layer 10, thereby keeping the upper layer in the intact state.

In the above, the electric charges charged on the upper piezoelectric ceramic layer 10 by the application of the voltage are discharged by turning the switch $S_1$ to the side b. The charging of the electric charges by the application of the voltage and the discharging thereof are repeated.

The electric charges charged on the lower piezoelectric ceramic layer 10 by the application of the voltage are also discharged by turning the switch $S_2$ to the side d. The charging of the electric charges by the application of the voltage and the discharging thereof are repeated.

As shown in Figs. 1(B) and 1(D), these piezoelectric ceramic layers 10 are bent.

The charging and discharging of these electric charges are alternately repeated on both the upper and lower piezoelectric ceramic layers 10 by the above-mentioned switching operation, thereby being able to stroke (displace) the piezoelectric actuator up and down to ensure the bimorph stroke, as shown in Fig. 2(A).

In Fig. 2(A), X indicates polarization (a polarization direction).

The piezoelectric ceramics are required to be polarized (X) for utilizing their piezoelectricity. In the polarized state, they are expanded to a positive electric field, and contracted to a negative electric field.

The above-mentioned voltage (DC voltage) Y may be applied, for example, at a voltage at which the piezoelectric ceramics can be at least polarized or higher, and within the range in which the use of the piezoelectric ceramics in the anti-electric field (the electric field which completely extinguishes the polarization) is not hindered.

The above-mentioned polarization is conducted, for example, by applying an appropriate level of an electric field in silicone oil having an appropriate temperature for a specified period of time. Higher temperature permits the polarization in a lower electric field. However, too high temperature results in reduced resistivity to cause current to flow, leading to dielectric breakdown. Polarization methods include an electric field cooling method in which after once heated at a temperature equal to or higher than the Curie point thereof, the piezoelectric ceramics are gradually cooled while applying the electric field.

As described above, the charging and discharging of the electric charges are alternately repeated on both the upper and lower piezoelectric ceramic layers 10, so that the problem of depolarization observed in the conventional bimorph piezoelectric actuators does not occur, because the depolarization direction X agrees with the voltage direction Y as shown in Fig. 2(A). No depolarization occurs, so that the expected amount of displacement can be ensured and unavoidable stoppage of a machine can be prevented.

The piezoelectric actuator of the present invention can be displaced by bending without applying voltages in the directions opposite to each other in the plate thickness direction to expand one and contract the other, and without allowing the piezoelectrically inactive shim member to intervene, as the prior-art piezoelectric actuators.

Like this, it is possible to take a stroke (displacement) S as shown in the drawing, even by the system of applying voltage to one of the upper and lower piezoelectric ceramic layers, forming a short circuit on the other side, and alternately repeating them, and the bimorph stroke can be ensured. The piezoelectric actuator of the present invention can be sufficiently used as a piezoelectric actuator in a textile machine such as a needle driving mechanism of a hosiery machine or a warp controlling mechanism of a loom, by a stroke (displacement) twice the total up and down as also shown in Fig. 2(A).

Even if DC voltage is continuously applied to the piezoelectric actuator for a textile machine for a long period of time, the problem of depolarization does not occur, and the piezoelectric actuator is not kept displaced, which permits smooth operation.

As the piezoelectric ceramics constituting the piezoelectric ceramic layers 10 used in the piezoelectric actuators of the present invention, various piezoelectric substances (crystals) can be used. Specific examples thereof include solid solutions of lead zirconate ($PbZrO_3$) and lead titanate ($PbTiO_3$), which are called PZT, lead zirconate ($PbZrO_3$), lead titanate ($PbTiO_3$), barium titanate ($BaTiO_3$) and barium phosphate. Additives such as Nb, Co and Mn can be added to the piezoelectric substances. The piezoelectric substances may be complexes thereof with polymers.

The piezoelectric ceramic layer 10 may be either a monolayer or a layer in which a plurality of piezoelectric ceramics are stacked.

For example, the upper piezoelectric ceramic layer 10 may be formed of 7 layers, and the lower piezoelectric ceramic layer 10 may also be formed of 7 layers to constitute the piezoelectric actuator consisting of 14 piezoelectric ceramic layers in all.

In the piezoelectric actuator of the present invention, for example, when the thickness of the upper piezoelectric ceramic layer 10 is changed from that of the lower piezoelectric ceramic layer 10 as shown in Fig. 2(B), the displacement is preferably more enlarged. For example, the whole thickness of the upper piezoelectric ceramic layer 10 is preferably thicker than that of the lower piezoelectric ceramic layer 10. That is to say, the whole thickness of the lower piezoelectric ceramic layer 10 is preferably thinner than that of the upper piezoelectric ceramic layer 10.

In each of the upper piezoelectric ceramic layer and the lower piezoelectric ceramic layer, the thickness of the piezoelectric ceramics may be changed. In that case, for example, it is preferred that they are gradually decreased in thickness outwardly from the center.

Further, when the piezoelectric ceramics in the piezoelectric ceramic layer 10 are successively increased in piezoelectric constant $d_{31}$ outwardly from the center, the displacement is preferably more enlarged.

Said piezoelectric constant $d_{31}$ is described. This is based on the piezoelectric constant (piezoelectric strain constant) in evaluation and measurement of piezoelectric ceramics.

Although there are various fundamental equations for describing piezoelectric phenomena, the d form may be employed. In the d form for determining the material constant in the piezoelectric ceramic, a mechanical variation (S: strain) and a electrical variation (D: electric displacement) are represented by the following equation (1):

Fundamental Equation

$$S = s^E T + dE \qquad (1)$$
$$D = dT + \varepsilon^T E$$

wherein D and E represent the vector quantities, assuming that the piezoelectric ceramic has high symmetry in its crystalline structure; T and S represent the symmetrical tensor quantities; d represents the piezoelectric strain constant; $s^E$ represents the elastic compliance at E = 0; and $\varepsilon^T$ represents the dielectric constant at T = 0.

In coefficient matrixes according to these vector quantities D and E and symmetrical tensor quantities T and S, one of independent coefficients which are not 0 is the $d_{31}$ coefficient.

Evaluating and measuring methods according to the so-called resonance methods treating piezoelectric bodies as resonators are established as IEEE Standards 176-1978 in U.S.A., as Electronic Material Industries Association Standards EMAS-6001-6006 in Japan, and internationally as IEC Standard Publication 483, 1st edition.

The piezoelectric coefficient $d_{31}$ is derived from the following equation (2):

$$d_{31} = \kappa_{31} \sqrt{\varepsilon^T_{33} \cdot s^E_{11}} \qquad (2)$$

wherein $\kappa$ is the electromechanical coupling coefficient, the length vibration of a rectangular plate is taken as $\kappa_{31}$, and the unit of the piezoelectric coefficient $d_{31}$ is C/N (m/V).

The piezoelectric coefficient $d_{33}$ in the longitudinal vibration of a column determined by the following equation (3) is a value for the whole stacked layers, and in the present invention, it is necessary that the piezoelectric coefficient $d_{31}$ for each of the stacked piezoelectric ceramic layers satisfies the above-mentioned equation.

$$d_{33} = \kappa_{33} \sqrt{\varepsilon^T_{33} \cdot s^E_{33}} \qquad (3)$$

wherein $\kappa$ is the electromechanical coupling coefficient, and the longitudinal vibration of a column is taken as $\kappa_{33}$.

The piezoelectric coefficient $d_{31}$ for each of the stacked piezoelectric ceramic layers can be adjusted by suitably selecting composition and materials such as solid solutions of lead zirconate ($PbZrO_3$) and lead titanate ($PbTiO_3$), which are called PZT, lead zirconate ($PbZrO_3$), lead titanate ($PbTiO_3$), barium titanate ($BaTiO_3$) and barium phosphate.

The piezoelectric actuator according to the present invention can be obtained, for example, in the following manner.

An organic solvent, a binder, a plasticizer, a dispersing agent and the like are added to a calcined powder of a piezoelectric ceramic, followed by mixing. Then, the resulting mixture was formed to a green sheet, which is stamped out to an appropriate size. A conductive paste for internal electrodes comprising Ag-Pd or Pd is screen printed, and a required number of these green sheets are stacked and press formed to integrate them. The green sheets are heated (usually at 500°C to 600°C) with a press, followed by burning, for example, at about 1200°C to obtain a stacked ceramic product. After cutting of the stacked product, insulators and external electrodes are attached thereto. The internal electrodes are electrically connected for every other layer in parallel. In addition, for the production of the stacked piezoelectric actuator, the above-mentioned technique of the stacked ceramic condenser called the green sheet method can be used. The resulting stacked product is polarized as described above for utilizing its piezoelectricity.

Although the above-mentioned piezoelectric actuator may be produced by integrating the sheets with an adhesive, it is preferably formed of the same material as a whole without use of the adhesive by integrating them with the conductive paste for internal electrodes allowed to exist therein as described above.

Integration of the same material without use of the adhesive can improve the adhesive strength, omit the adhesion step, and reduce cost. Moreover, use of the same material can match the coefficients of thermal expansion.

The piezoelectric actuators for textile machines of the present invention will be described below taking the cases of a needle driving mechanism of a hosiery machine and a warp controlling mechanism of a loom.

As shown in Fig. 5, in a hosiery jacquard knitting machine such as a jacquard circular knitting machine or a jacquard flat knitting machine, a needle driving mechanism (needle driving piezoelectric actuator) is used for transmitting a patterning procedure memorized in a memory such as a floppy disk to an up-and-down movement of knitting needles. A number of needle driving mechanisms 15 governing the up-and-down movement of the knitting needles 14 are disposed around a knitting cylinder 16, and connected to a patterning controller 17. The patterning procedure is supplied from the patterning controller 17 to make the up-and-down movement of the knitting needles 14, thereby conducting jacquard knitting of a hosiery. Although not shown in the drawing, a number of needle driving jacks having protruded butts are disposed under the knitting needles, and the knitting needles are brought into abutting contact with upper portions of the jacks. Knitting yarns 18 are supplied from bobbins 19 to the knitting cylinder 16, and the needle driving mechanisms 15 are allowed to act on the needle driving jacks to make the up-and-down movement of the knitting needles 14 as described above, thereby conducting jacquard knitting of the hosiery. The needle driving mechanisms 15 may be allowed to act on the knitting needles 14 directly.

In one embodiment of the needle driving mechanism 15, as shown in Fig. 3, piezoelectric actuators 20 are supported by a support (housing) 21 in multiple stages, and fingers 22 are connected to ends of the piezoelectric actuators 20. Leading ends of the fingers 22 are protruded outward through openings 24 of a stopper 23 of the support 21, and each of the piezoelectric actuators 20 is allowed to operate through a lead wire 25 by the patterning controller 17. Further, operation of the fingers 22 makes the up-and-down movement of the knitting needles 14 as described above, thereby conducting jacquard knitting of the hosiery.

An example of the needle driving operation is described for the piezoelectric press system. As shown in Fig. 4(B), the application of voltage from the patterning controller 17 to the piezoelectric actuator 20 through the lead wire 25 (or application of a positive pulse) bends the piezoelectric actuator 20 to deflect the finger 22, for example, downward, which causes no pressing of the finger against the butt 27 of the needle driving jack 26. Accordingly, the needle driving jack 26 keeps the vertical position. As a result, the butt 28 for a lifting cam protruded at a lower end of the needle driving jack 26 comes into engagement with the lifting cam 29 to cause the needle driving jack 16 and the knitting needle 14 brought into abutting contact with an upper portion thereof to move upward, resulting in formation of a knitted loop with the knitting needle 14. On the other hand, as shown in Fig. 4(A), no application of voltage (or application of a negative pulse) leads to no bending of the piezoelectric actuator 20, so that the butt 27 of the needle driving jack 26 is pressed. As a result, the butt 28 for the lifting cam protruded at the lower end of the needle driving jack 26 does not come into engagement with the lifting cam 29 to give no knitting operation to the knitting needle 14 brought into abutting contact with the upper portion of the needle driving jack 26.

Then, a piezoelectric actuator used in a warp controlling mechanism of a loom is described according to Figs. 6 and 7.

With respect to the general principle of the loom, in the case of a plain weave, warp yarns are passed through heddles, and divided into two groups by the up-and-down movement of the heddles to form a shedding. Then, a weft yarn is passed through the shedding with a shuttle, and pressed to a cloth fell. Thereafter, another combination of the warp yarns is formed, followed by passing of the weft yarn, thus advancing weaving.

The piezoelectric actuator is used for control of the heddles and control of the warp yarns as well.

As shown in Figs. 6 and 7, a finger 22 is attached to an end of a piezoelectric actuator 20, which is electrically connected to a heddle controlling mechanism although not shown in the drawings, and the piezoelectric actuator 20 is operated to control heddles (not shown in the drawings) connected to a lower portion of a controlling rod 31, and warp yarns as well by operation of the finger 22. When voltage (pulse) is applied to the piezoelectric actuator 20, the piezoelectric actuator 20 is displaced by bending, and the finger 22 also moves following the displacement by bending (bending movement) of the piezoelectric actuator 20, because of connection of the finger 22 to the piezoelectric actuator 20. The finger 22 which is provided with a hook 30 (or a hook hole) comes into engagement with the controlling rod 31 which is similarly provided with a hook or a hole 310. On the other hand, when voltage (pulse) is not applied to the piezoelectric actuator 20, the finger 22 does not come into engagement with the controlling rod 31, and keeps a position apart therefrom. Thus, the finger 22 can selectively come into engagement with and maintain the controlling rod 31. As described above, the controlling rod 31 is connected to the heddles at a lower portion of the hook or the hole 310 although not shown in the drawings. The controlling rod 31 operatively associates with the heddles to control the heddles and to control the warp yarns.

When the piezoelectric actuator of the present invention is used in the warp controlling mechanism of the loom or the needle driving mechanism of the hosiery machine as described above, it preferably takes such a form as does not prevent the bending movement thereof, as described in the above-mentioned embodiments.

Taking the case of the needle driving mechanism 15 of the hosiery machine, a spherical body 34 is attached to a rear end of the piezoelectric actuator 20, and the rear end of the piezoelectric actuator 20 to which the spherical body 34 is attached is inserted in a groove 36 of a piezoelectric actuator fitting portion 35 of the support 21. A spherical portion of the spherical body 34 is made movable in the groove 36 of the piezoelectric actuator fitting portion 35, thereby making the rear end of the piezoelectric actuator 20 movable.

Further, a spherical body 34 similar to the above is also attached to a leading end of the piezoelectric actuator 20. The spherical body 34 is made movable in a rear end of the finger 22, thereby also making the leading end of the piezoelectric actuator 20 movable.

Furthermore, a rotative body 38 is fixedly attached to an intermediate position between the rear end and the leading end of the piezoelectric actuator 20, and both ends of the rotative body 38 are rotatably mounted on a rotative body fitting portion (intermediate fulcrum portion) 39 of the support 21 so that the movement of the intermediate position between the rear end and the leading end of the piezoelectric actuator 20 is not stopped with the rotation of the rotative body 38.

According to this system and apparatus, the piezoelectric actuator 20 is freely moved, its movement is not prevented, and the intermediate fulcrum is formed. It has therefore the excellent advantages that the needle driving speed can be remarkably increased, and that the life of the piezoelectric actuator 20 is prolonged.

In this respect, the piezoelectric actuator is also similarly used in the warp controlling mechanism of the loom. A spherical body 34 is attached to an upper end of the piezoelectric actuator 20 and movably supported in a groove 36 formed in the support (controlling rod support) 21, and a lower end thereof is movably connected to the finger 22. An intermediate position between the upper end and the lower end of the piezoelectric actuator 20 is fixed to a rotative body 38 rotatably mounted on the controlling rod support 21, and the upper end and the lower end of the piezoelectric actuator 20 and the intermediate position therebetween are made movable following the bending movement of the piezoelectric actuator 20 so as not to prevent the bending movement of the piezoelectric actuator 20. This can provide the advantages that the speeds of the controlling operation of a controlling rod 31 and the selection controlling operation of the heddles and further warp yarns can be increased, that the life of the piezoelectric actuator 20 is prolonged, and that the applied voltage can be more reduced.

Although the specific embodiments of the invention have been described, it is to be understood of course that these embodiments are not intended to limit the scope of the invention and that various changes and modifications can be made in the invention without departing from the spirit and scope thereof.

In the above-mentioned embodiments, the use of switches has been shown as an example. However, other means may be used as long as they can exhibit the switching function, and, for example, various switching elements made up of field effect transistors (FETs) and the like can be used.

The warp controlling mechanisms of the looms using the piezoelectric actuators of the present invention are mainly used in jacquard machines in which cards perforated according to jacquard patterns proposed by Jacquard are used to pull up only hooks at positions corresponding to holes of the cards, thereby pulling up only warp yarns connected to the hooks through harness cords, and sheds are formed between the warp yarns pulled up and warp yarns remained at original positions.

The present invention can also be applied as piezoelectric actuators of the scooping-up system instead of the above-mentioned actuators of the press system in the needle driving mechanisms of the hosiery machines.

The effects obtained by the typical embodiments of the piezoelectric actuators of the invention disclosed in this application are briefly described as below.

That is to say, according to the present invention, the depolarization direction can be allowed to always agree with the direction of voltage (electric field) applied, so that the problem of depolarization does not occur to cause no decrease in the amount of displacement due to depolarization. Accordingly, the expected amount of displacement can be ensured.

Previously, it has been said that elements other than the bimorph elements are small in the amount of displacement and actually unsuitable for use. According to the present invention, however, application to the piezoelectric actuators for textile machines becomes possible, and the bending type piezoelectric actuators displaceable by bending can be provided.

## Claims

1. A piezoelectric actuator for a textile machine which is not depolarized, said actuator comprising a plurality of piezoelectric ceramic layers stacked, in which charging of electric charges by application of voltage to one of said plurality of piezoelectric ceramic layers and discharging thereof are alternately repeated by switching operation according to a switching element.

2. A piezoelectric actuator according to claim 1, in which the voltage applied is direct current voltage.

3. A piezoelectric actuator according to claim 1, in which only the plurality of piezoelectric ceramic layers are stacked without allowing a shim member to intervene therebetween.

4. A piezoelectric actuator according to claim 1, in which said piezoelectric actuator is a piezoelectric actuator in a needle driving mechanism of a hosiery machine.

5. A piezoelectric actuator according to claim 1, in which said piezoelectric actuator is a piezoelectric actuator in a warp controlling mechanism of a loom.

Fig. 1 （A）

Fig. 1 （B）

Fig. 1 （C）

Fig. 1 （D）

Fig. 2 (A)

Fig. 2 (B)

Fig. 3

Fig. 4 (A)

Fig. 4 (B)

Fig. 5

Fig. 6 (A)

Fig. 6 (B)

## Fig. 7 (A)

21

34

20

38

34

22

30

31

310

## Fig. 7 (B)

21

34

20

38

34

22

30

31

310

## Fig. 8 （A）

## Fig. 8 （B）

Fig. 9

**European Patent Office**

**EUROPEAN SEARCH REPORT**

Application Number

EP 98 11 6071

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| Y | US 4 678 957 A (HARNDEN JR JOHN D ET AL) 7 July 1987 * column 4, line 24 - column 5, line 16 * * column 14, line 26 - column 15, line 2; figure 1B * | 1-4 | H01L41/09 H01L41/04 |
| Y | EP 0 784 349 A (WAC DATA SERVICES CO LTD) 16 July 1997 * the whole document * | 1-4 | |

TECHNICAL FIELDS SEARCHED (Int.Cl.6)

H01L

The present search report has been drawn up for all claims

| Place of search | Date of completion of the search | Examiner |
|---|---|---|
| THE HAGUE | 10 December 1998 | PELSERS, L |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**                    EP 98 11 6071

This annex lists the patent family members relating to the patent documents cited in the above-mentioned European search report.
The members are as contained in the European Patent Office EDP file on
The European Patent Office is in no way liable for these particulars which are merely given for the purpose of information.

10-12-1998

| Patent document cited in search report | | Publication date | Patent family member(s) | | Publication date |
|---|---|---|---|---|---|
| US 4678957 | A | 07-07-1987 | US | RE33568 E | 09-04-1991 |
| EP 0784349 | A | 16-07-1997 | JP | 9191134 A | 22-07-1997 |
| | | | JP | 9191135 A | 22-07-1997 |
| | | | JP | 9191136 A | 22-07-1997 |
| | | | JP | 9191137 A | 22-07-1997 |
| | | | CN | 1164767 A | 12-11-1997 |
| | | | US | 5834879 A | 10-11-1998 |

EPO FORM P0459

For more details about this annex : see Official Journal of the European Patent Office, No. 12/82